# EUROPEAN PATENT APPLICATION

(11) **EP 2 112 518 A1**
(43) Date of publication of application: **28.10.2009**
(21) Application number: 08155159.0
(22) Date of filing: 25.04.2008
(51) Int. Cl.: G01R 31/34, H01R 39/58

(54) **Brush wear monitor**

(71) Applicant: Alstom Technology Ltd, 5400 Baden (CH)
(72) Inventor: Mark, Bernhard, 79761, Waldshut (DE); Hobelsberger, Max, 5303, Würenlingen (CH)
(74) Representative: Dimper, Dieter

(57) **Abstract**

Provided is a brush wear monitoring system for an electrical machine characterized by at least one brush having a mounted flag 13,14 so as to define a monitored brush, and an electrical recording circuit. The circuit comprising at least one impedance device 6 for providing impedance characteristics to the circuit and switches, having a state defined by the interaction between the flags 13,14 and the circuit wherein brush wear causes the interaction. Finally a recording device 8 in the circuit is used to detect changes in electrical characteristics of the circuit thereby providing the means of triggering a brush wear alarm.

## Description

### FIELD OF THE INVENTION

The invention relates to brushes used for transferring current in electrical machines such as electric motors or alternators, and more specifically to brushes designed to preferentially wear. More particularly the invention relates to a monitoring system for identifying critical brush wear.

### STATE OF THE ART

Brush gear mechanisms are used extensively in certain motors, generators and other rotating electrical machinery to conduct current between stationary and rotating parts (commutators or slip rings). To avoid or at best minimise the wear of the rotating parts, which are typically constructed of copper or brass, brushes are made of soft materials, such as carbon and graphite, so as to preferentially wear. It is important that brush wear is monitored to ensure that the brushes do not wear beyond a minimum level as a completely worn brush can lead to electrical arcing resulting in machine part failure.

One established practice of monitoring brush wear is to install brush assemblies in brush houses with visual inspection means to enable operator inspection. Due to human factors however machine failures still occur. For other reasons, including cost reduction it maybe desirable to at least supplement such monitoring with automated monitoring. As a result instrumented brush-monitoring systems have been developed.

Monitoring of the excitation voltage supplied a brush is one known method of monitoring brush wear. For example GB1564384 describes a process of monitoring the signature of the excitation voltage for unusual high-energy noise spikes created by brush arcing. It does this by using sensors connected to each brush and employing comparative algorithms and filtering means to analysis the data. US 4451786 and CA 1194112 also teach of similar methods with similar disadvantages including that a fault condition i.e. arcing but not brush wear, is monitored and so the method is reactive rather than preventative. Further disadvantages include the fact that monitoring involves complex signature filtering and interpretation and so is open to error. The methods also inherently lack the ability to utilize one sensor to monitor multiple brushes.

JP6141513 discloses another brush monitoring method that utilizes brush electrical signatures relying only on inputs of armature current and an armature revolution count to calculate brush wear. As the method does not directly measure or detect brush wear the accuracy of the method is limited and yet despite analyses simplicity still requires a sensor per monitored brush.

Larger machines typically have 30 or more brushes and therefore to improve inherent monitoring reliability and simplify maintenance and installation it is advantageous for these systems to have as few sensors as possible. The requirement for the cited teaches to have a sensor per monitored brush therefore disadvantages all the above teachings

### SUMMARY OF THE INVENTION

It is an object of the invention to provide an improved means and apparatus for triggering a worn brush alarm for an electrical machine.

This is achieved by means of the subject matters of the independent claims. Advantageous embodiments are given in the dependent claims.

The invention is based on the general idea of utilising the wear movement of a brush to switch a recording circuit. Accordingly, one aspect provides a worn brush monitoring system for an electrical machine characterized by at least one brush having a mounted flag in wear movable communication with the brush and an electrical recording circuit. The circuit comprising at least one impedance device (e.g. a resistor) for providing impedance characteristics to said circuit and switches, having a state defined by the interaction between the flags and the circuit wherein brush wear causes the interaction. The switching of the circuit remote from the brush, enabled by the flag being mounted on the brush, minimises the fouling potential of the circuit as well as enabling the system to be retrofitted to existing installations without modification or replacement of the brush or brush housing. Finally a recording device detects changes in electrical characteristics of the circuit resulting from changes to the switch state thereby providing the means of triggering a worn brush alarm.

In another aspect of the invention the switch comprises a contact plate wherein contact between a flag of a worn brush and the contact plate establishes electrical communication between the worn brush and the recording device. In this way the characteristics of the current through the brushes can be used to monitor for a worn brush without the need for complex filtering or interpretation. Further the contact plate may be interactable with more than one flag so by providing one means of brush monitoring using a single recording circuit with recorder eliminating the need for multiple recording devices. In yet another aspect the contact plate is an impedance device wherein the impedance of the contact plate is dependant on its length. In a multi brush monitoring arrangement flags contact the contact plate along different points resulting in the contact plate imparting different impedances to the circuit wherein the difference can be used by the single recording device to identify which of a series of monitored brushes is worn.

Brush housings are characterised by having conductive foulant that can interfere with the operation of monitoring systems reducing their reliability. Another embodiment of the invention ameliorates this problem by providing a contact plate having an insulating layer pierceable by the flag such that piercing results in contact between the flag and the contact plate.

Another aspect provides an arrangement wherein the circuit monitors more than one brush and includes an impedance device for each brush. The impedance devices are in series while the switches are parallel to each impedance device so by providing another arrangement of the invention for monitoring more than one brush with a single recording device.

A yet further aspect includes a reading device for querying the recording device, including by wireless communication. An example of such a wireless communication system is RFID technology providing cost effective remote communication means.

A further aspect provides an alternative circuit arrangement wherein the flag is a capacitive flag comprising two electrically continuous flag plates. In this arrangement the circuit is an AC powered circuit and the switch comprises switch plates at a first end and a second end of the switch. Interposition of the capacitive flag plates between the switch plates changes the switch state.

An alternative aspect includes a conductive flag capable of bridging a switch wherein bridging of the switch changes the switch state.

The system of the various aspects can be powered by various means including an energy-harvesting module for powering the recording device harnessing electrical energy or AC (voltage or current) supplied to or from the brushes.

In another aspect of the invention the electrical characteristic is the high frequency component of the brushes potential wherein recording of the electrical characteristic is enabled by the system further comprising capacitive grounding to earth of the harvesting module so as to provide a reference point for measuring the high frequency component. In this way the high frequency component of the brush potential, where in this specification "high frequency" is defined as greater or equal to 10 Hz, can be used to monitor brush wear without the need for complex filtering or interpretation.

Another aspect on the invention provides a brush suitable for use in a brush wear recording circuit wherein the circuit compromises: one or more impedance devices; a capacitance switch, in parallel to each impedance device, with first and second switch plates; and a recording device for recording changes in the electrical characteristics of the circuit as a result of changing of state of any one the switches The brush is characterized by a flag mounted on the brush wherein the flag comprises first and second electrically continuous flag plates extending outwards from the brush so as to form a capacitive brush flag. The outward extension of the flag plates enables interposition of the flag plates between the switch plates as a result of brush wear so by changing the switch state. Further, the combined outer surface area of the flag plates seeable by the switch plates is >700 mm³.

A further object of the invention is to overcome or at least ameliorate the disadvantages and shortcomings of the prior art or provide a useful alternative.

Other objectives and advantages of the present invention will become apparent from the following description, taken in connection with the accompanying drawings wherein by way of illustration and example, an embodiment of the invention is disclosed.

### BRIEF DESCRIPTION OF THE DRAWINGS

By way of example, an embodiment of the invention is described more fully hereinafter with reference to the accompanying drawings, in which:
Figure 1 is a schematic diagram of a brush monitor system of the invention with multiple recording devices;
Figure 2 is a schematic diagram of another embodiment of the invention having a contact plate;
Figure 3 is a schematic diagram another embodiment of the invention where multiple brushes are monitored; and
Figure 4 is a detailed view of a capacitive brush flag of the monitoring system of Fig. 3

### DETAILED DESCRIPTION OF THE INVENTION

Preferred embodiments of the present invention are now described with reference to the drawings, wherein like reference numerals are used to refer to like elements throughout. In the following description, for purposes of explanation, numerous specific details are set forth in order to provide a thorough understanding of the invention. It may be evident, however, that the invention may be practiced without these specific details.

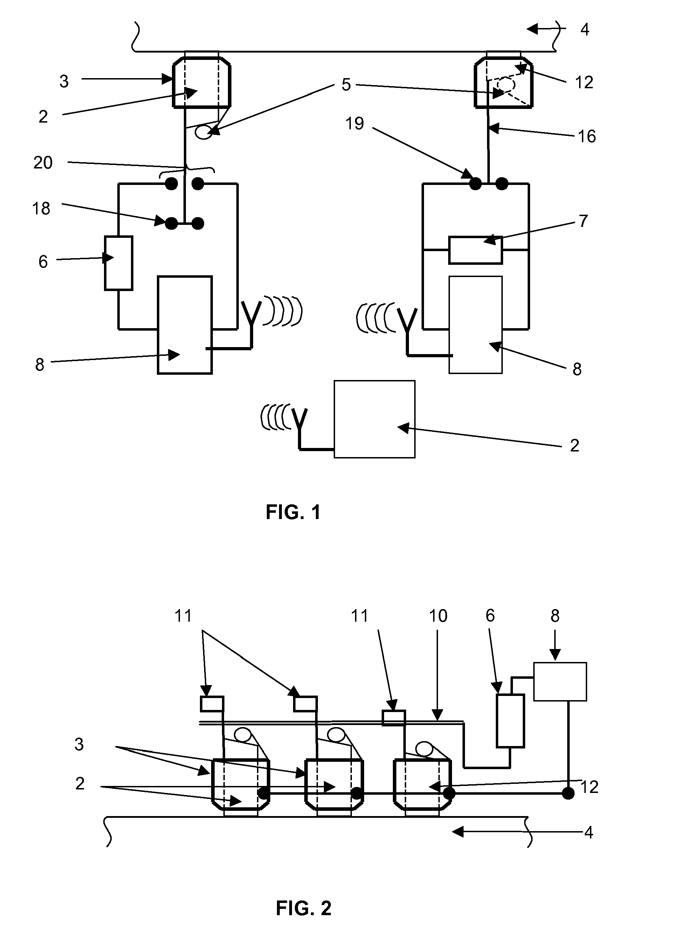

Fig. 1, 2 and 3 shows brush monitoring systems comprising brush flags 11, 13, 14, 18,19 mounted on brushes 2 interacting with a recording circuit so as to identify when a brush is worn wherein the recording circuit comprises switches, impedance devices and a recorder device 8.

Brush flags are mounted preferably on the hooks 16 of brushes 2 and extend out from the brush 2 so as to form part of the switch of the circuit where interaction between the flag and the circuit changes the state of the switch 20. In this way flags and how they interact with the circuit defines the switch state while the mounting of the flags is the means of ensuring that flags move with the wear movement of the brush. In this way a direct link between brush-wear and changes to the circuit is created.

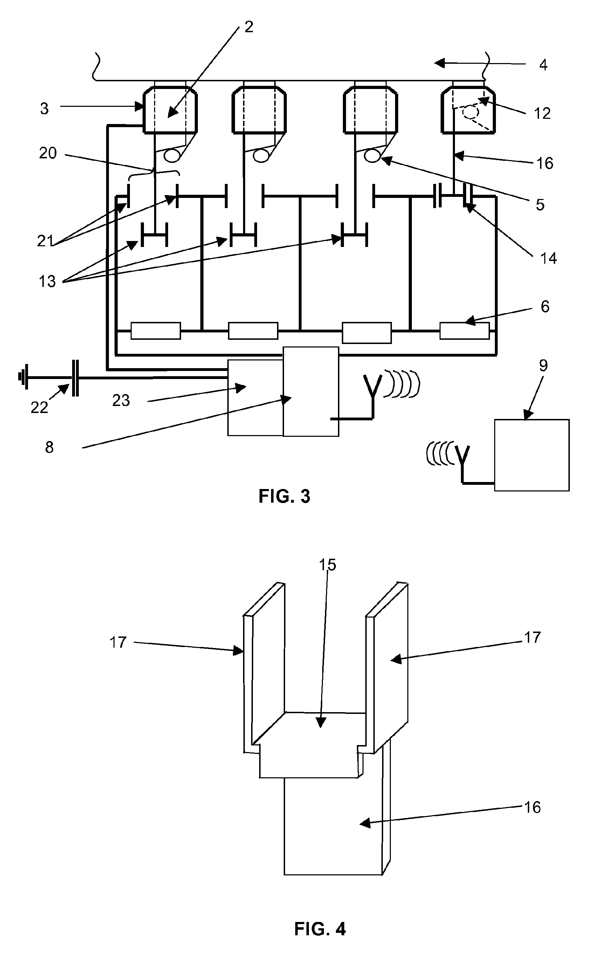

The form of the flag differs depending on the embodiment and form of the switch but includes forms: suitable for bridging a switch by ohmic contact as shown in Fig 1; that provide means to electrically communication between brushes and a contact plates as shown in Fig 2; with capacitive capability as shown in Fig 3; or with inductive characteristics.

In the preferred embodiment where switch closure is by bridging means as shown in Fig 1, as a brush wears to a predefined point the brush flag 18 relocates such that it forms a bridges 19 between the two ends of a switch thereby changing the circuit state from open to closed enabling current flow around a powered recording circuit. A resistive device, within the circuit either in series or parallel to the switch, enables recording by a recorder 8 where the recording is of an electrical characteristic preferably current or voltage. A circuit can be provided for each brush or a single circuit can monitor more than one brush. In the multi brush monitoring arrangement preferably resistors are located in parallel to each switch in an arrangement similar to that shown in Fig 3 where in the Figure the capacitive flag switching is replaced with bridging switching means.

In the preferred embodiment where switch closure is by capacitive means as shown in Fig 3 the recording circuit is an AC powered recording circuit and the switch preferably comprises two substantially parallel switch plates 21. The capacitive flag 13 also comprises preferably a plate or more preferably two substantially parallel flag plates 17 joined by a conducting plate 16, as shown in Fig 4, interpositionable between the switch plates Fig 3, 14. When so interpositioned the proximity of the plates enables AC (alternating current) flow in the circuit. The conducting plate 15 has a secondary purpose as a mounting plate for attaching the flag to a flag hook 16 as shown in Fig 4. The substantially parallel nature of the plates enables contact less interpositioning with tight gap tolerance improving the capacitive nature of the flag plates. Insulation of the plate is provided in an embodiment so as to prevent plate contact and overcome bridging of the plate gap with conductive fouling medium commonly found in brush housings.

The surface area and separation distance of the capacitance plates of the switch and flag defines the AC flow of the circuit where the optimum and workable size of the plates is a compromise between these two factors. For installation reasons it is preferable that plate size be kept to a minimum to optimise equipment layout in the confined space of a brush housing, this however necessitates narrower plate gap and tight gap tolerances. It is therefore preferably that the surface area of the capacitive flag seeable by the switch plates is preferably > 200 mm³ more preferably > 700 mm³ and most preferably > 1000 mm³. To prevent interfere with the workings of the brushes however the maximum flag area is preferably no greater than 1500 mm³ to 2500 mm³.

In another preferred embodiment as shown in Fig 2 flags 11 provides a means of electrically communication between worn brushes and a recording device where in a preferred embodiment the communication establishes a current flow via a series of impedance devices 6, 22. A contact plate 10, normally isolated from brushes, provides the means that a flag of a worn brush communicates with a recorder in a recording circuit. Characteristics that can be measured by such an arrangement include the high frequency component of brush potential, voltage and current. A single contact plate 10 can serve as a conducting means for several monitored brushes by its length extending proximal to several brush flags such that flags interact with the contact plate 10 by contacting the plate along different points along its length. In an embodiment the contact plate 10 is covered with insulation that is pierceable by brush flags 11 for example by the flag 11 having a piercing element in the form of a sharpened point. In order for the insulation to be pierceable, insulation is made preferably from deformable material with prefabricated slots. Brush wear movement forces the sharpened point to penetrate the slot by pushing aside deformable side wall material of the slots. This enables flags 11 to contact the contact plate 10 while preventing contamination of contact plate with conductive fouling material.

In an alternate embodiment the contact plate 10 is resistive having an impedance characteristic depend on length. In this way the characteristic voltage or current presented to the recording device varies depending on where along the length of the contact plate brush flags make ohmic contact with the contact plate 10.

Connection of the recording device to the contact plate and preferably brush holders, as shown in Fig 2, completes the recording circuit. This embodiment preferably further includes an in series "test voltage source ". The test voltage source causes current to flow when the contact plate is electrically connected to the brush and brush holder as a flag contacts the contact plate.

Preferably the recorder 8 is a read write RFID (radio frequency identification device) device although it could be any known device capable of recording any change in the electrical characteristic of the recording circuit. Preferably the recorder further communicates with a wireless reading device 9, such as a RFID reader, capable of triggering an alarm. Alternatively the recorder 8 may directly trigger a wear alarm.

In an embodiment as shown in Fig 3 power is supplied to the recording circuit or device preferably by an energy harvesting module 23 for harvesting the energy of preferably the current flow to or from the brushes utilising the high frequency component of the current flow. In a capacitive harvesting method the high frequency component of the voltage between brush and for example ground or another slipring generates power preferably by a transformer. Ground to earth provides a reference point so by enabling use of the high frequency component of brush potential as a trigger for brush wear.

In another embodiment harvesting is by an inductive method whereby the inductive method utilises the high-frequency content of the excitation current flowing to and through the brush to generate power.

Although the invention has been herein shown and described in what is conceived to be the most practical and preferred embodiment, it is recognized that departures can be made within the scope of the invention, which is not to be limited to details described herein but is to be accorded the full scope of the appended claims so as to embrace any and all equivalent devices and apparatus.

### REFERENCE NUMBERS

### Numbers used in the figures

- 2.: Brush
- 3.: Brush holder
- 4.: Slip ring or commutator
- 5.: Brush spring
- 6.: Impedance device series
- 7.: Impedance device parallel
- 8.: RFID type recording device
- 9.: RFID reader
- 10.: Contact Plate
- 11.: Ohmic flag
- 12.: Worn brush
- 13.: Capacitive flag with flag plates
- 14.: Capacitive flag closing switch
- 15.: Capacitive flag conducting plate
- 16.: Flag hook
- 17.: Capacitive flag plate
- 18.: Conductive flag
- 19.: Conductive flag closing switch
- 20.: Switch
- 21.: Switch plates
- 22.: High voltage capacitor to ground
- 23.: Energy harvesting module

## Claims

1. A worn brush monitoring system for an electrical machine, said system **characterized by**:
at least one said brush (2) having a mounted flag (13,18) in wear movable communication with said brush; (2) and
an electrical recording circuit comprising:
at least one impedance device (6,7) for providing impedance characteristics to said circuit;
switches (20), having a state defined by the interaction between said flags and said circuit wherein brush wear causes said interaction; and
a recording device (8) for detecting changes in electrical characteristics of said circuit resulting from changes to said switch state.

2. The system of claim 1 wherein said switch comprises a contact plate (10) wherein contact between a flag of a worn brush and said contact plate (10) establishes electrical communication between said worn brush and said recording device (8).

3. The system of claim 2 wherein said contact plate (10) is interactable with more than one said flag.

4. The system of claims 2 or 3 wherein said contact plate (10) is an impedance device wherein the impedance of the contact plate is dependant on its length.

5. The system of any one of claims 2 to 4 wherein said contact plate (10) has an insulating layer pierceable by said flag such that piercing results in contact between said flag and said contact plate (10).

6. The system of any one of claims 1 wherein said circuit monitors more than one brush (2) and includes an impedance device for each said brush (2).

7. The system of claim 6 wherein said impedance devices are in series and a said switch (20) is parallel to each said impedance device.

8. The system any one of claims 1 to 7 further including a reading device (9) for querying said recording device (8).

9. The system of claim 8 wherein said recording device (8) and said reading device (9) communicate wirelessly.

10. The system of claim 9 wherein said recording device (8) is a RFID device and said reader (9) is a RFID reader.

11. The system of any one of claims 1, 6, 7,8, 9 or 10 wherein:
said flag (13,18) is a capacitive flag (13) comprising two electrically continuous flag plates (17);
said circuit is an AC powered circuit; and
said switch (20) comprises switch plates (21) at a first end and a second end of said switch (20).
wherein interposition of said capacitive flag plates (17) between said switch plates (21) changes said switch state.

12. The system of any one of claims 1, 6, 7,8, 9 or 10 wherein said flag is a conductive flag (18) capable of bridging a said switch (20) wherein bridging of said switch changes said switch state.

13. The system of any one of claims 1 to 12 wherein said recording circuit further includes an energy harvesting module (23) for powering said recording device (8) by harnessing electrical energy supplied to or from said brushes (2).

14. The system of claim 13 wherein said harvesting module harvests by capacitive methods (23).

15. The system of claim 13 wherein said harvesting module harvests by inductive methods.

16. The system of any one of claims 13 or 15 wherein said electrical characteristic is the high frequency component of the brushes potential wherein recording of said electrical characteristic is enabled by the system further comprising capacitive grounding to earth of said harvesting module (23) so as to provide a reference point for measuring said high frequency component.

17. A brush for a brush wear recording circuit wherein the circuit comprises:
one or more impedance devices;
a capacitance switch (20) in parallel to each impedance device wherein said switch comprises first and second switch plates (21) ; and
a recording device (8) for recording changes in the electrical characteristics of said circuit as a result of switch state changes,
said brush **characterized by** a flag (13) mounted on said brush wherein said flag (13) comprises first and second electrically continuous flag plates (17) extending outwards from said brush (2) so as to form a capacitive brush flag (13)
wherein said outward extension of said flag plates (17) enables interposition of said flag plates (17) between said switch plates (21) as a result of brush wear so by changing said switch state,
wherein further the combined outer surface area of said flag plates (17) seeable by said switch plates (21) is >700 mm³.

18. The brush of claim 17 wherein said flag plates (17) are insulated.

19. The brush of claim 17 or claim 18 wherein said flag plates (17) are substantially parallel.

20. A brush for a brush wear recording circuit wherein the circuit comprises:
one or more impedance devices;
a switches (20), comprising a contact plate (10) covered with insulation
wherein said insulation includes slots
a recording device (8) connected to said contact plate, for recording changes in the electrical characteristics of said circuit resulting from switch state changes
wherein said brush is **characterized by** a flag (13), mounted on said brush, having a piercing element for piercing a said slot as a result of brush wear whereby piercing said slot changes said switch state.

## Amended claims

### Amended claims in accordance with Rule 137(2) EPC.

**1.** A worn brush monitoring system for monitoring more than one brush (2) of an electrical machine, said system comprising:
a plurality of said brushes (2) having a mounted flag (11) in wear movable communication with each said brush; (2) and
an electrical recording circuit comprising:
at least one impedance device (6) for providing impedance characteristics to said circuit;
switches, having a state defined by the interaction between said flags (11) and said circuit wherein brush wear causes said interaction; and
a recording device (8) for detecting changes in electrical characteristics of said circuit resulting from changes to said switch state, the system **characterized by**:
said switch comprising a contact plate (10), interactable with more than one said flags (11) along different points along its length and having an impedance dependent on its length wherein interaction with the contact plate (10) along different points results in the contact plate (10) imparting different impedances to the circuit wherein the difference is used by the recording device (8) to identify which of a series of monitored brushes (2) is worn

**2.** The system of claims 1 wherein said contact plate (10) has an insulating layer pierceable by said flag (11) such that piercing results in contact between said flag (11) and said contact plate (10).

**3.** The system of claim 2 wherein the insulating layer is pierceable by a piercing element of said flag (11).

**4.** The system of claim 3 wherein the piercing element is a sharpened point.

**5.** The system any one of claims 1 to 4 further including a reading device (9) for querying said recording device (8).

**6.** The system of claim 5 wherein said recording device (8) and said reading device (9) communicate wirelessly.

**7.** The system of claim 6 wherein said recording device (8) is a RFID device and said reader (9) is a RFID reader.

**8.** The system of any one of claims 5 to 7 wherein said recording circuit further includes an energy harvesting module (23) for powering said recording device (8) by harnessing electrical energy supplied to or from said brushes (2).

**9.** The system of claim 8 wherein said harvesting module (23) harvests by capacitive methods.

**10.** The system of claim 8 wherein said harvesting module (23) harvests by inductive methods.
